# EUROPÄISCHE PATENTSCHRIFT

(11) **EP 2 212 932 B1**
(45) Veröffentlichungstag und Bekanntmachung des Hinweises auf die Patenterteilung: **31.12.2014**
(21) Anmeldenummer: 08802068.0
(22) Anmeldetag: 12.09.2008
(51) Int. Cl.: H01L 41/04, B05B 17/06

(54) **SCHALTUNGSANORDNUNG UND VERFAHREN ZUM VERSORGEN EINER KAPAZITIVEN LAST**
CIRCUIT ARRANGEMENT AND METHOD FOR SUPPLYING A CAPACITIVE LOAD
CIRCUIT ET PROCÉDÉ D'ALIMENTATION D'UNE CHARGE CAPACITIVE

(30) Priorität: 02.11.2007 DE 102007052887
(43) Veröffentlichungstag der Anmeldung: 04.08.2010
(73) Patentinhaber: Braun GmbH, 61476 Kronberg/Taunus (DE)
(72) Erfinder: SCHOBER, Uwe, 61479 Glashütten (DE); SCHÄFER, Robert, 60486 Frankfurt/Main (DE); KRESSMANN, Frank, 65760 Eschborn (DE)
(74) Vertreter: Hirsch, Uwe Thomas M.H.
(86) Internationale Anmeldenummer: PCT/EP2008/007508
(87) Internationale Veröffentlichungsnummer: WO 2009/056189

(56) Entgegenhaltungen:
- EP-A- 0 677 335
- FR-A- 2 829 314
- JP-A- 6 006 134
- US-A1- 2006 017 350

## Beschreibung

Schaltungsanordnungen zur Versorgung einer kapazitiven Last, insbesondere eines bipolaren piezoelektrischen Aktuators, mit einer Wechselspannung aus einer Gleichspannungsquelle sind bekannt.

So zeigt die DE 101 22 065 A1, dass ein piezoelektrischer Aktuator, der im Brückenzweig einer H-Brückenschaltung eingeschaltet ist, von der H-Brückenschaltung eine Wechselspannung zugeführt bekommt, die den schwingungsfähigen piezoelektrischen Aktuator zu Schwingungen anregt. Die H-Brückenschaltung weist dazu vier FET auf, die von einem spannungsgesteuerten Oszillator angesteuert werden.

Nachteilig ist bei dieser Schaltungsanordnung, dass vier Leistungs-FET benötigt werden und eine aufwendige Ansteuerelektronik für die FET notwendig ist.

Die US 2006/0017350 A1 zeigt einen Ansteuerkreis für ein bspw. einen Ton oder eine Schwingung erzeugendes piezoelektrisches Element mit ferner einem Schaltelement und einer Spule. Die Spule ist dem piezoelektrischen Element parallel geschaltet. Durch das zwischen der Spule und dem piezoelektrischen Element angeordnete Schaltelement wird das Anlegen einer Spannung an das piezoelektrische Element in regelmäßigen Intervallen an- und ausgeschaltet. Das Schalten dieses Schaltelements erfolgt durch einen separaten Uhrenschaltkreis.

Aufgabe der vorliegenden Erfindung ist es daher, eine Schaltungsanordnung und ein Verfahren zur Verfügung zu stellen, mit der eine kapazitive Last, insbesondere ein piezoelektrischer Aktuator, mit einer einfachen Schaltungsanordnung bipolar angetrieben werden kann.

Diese Aufgabe wird von einer Schaltungsanordnung nach Anspruch 1 und einem Verfahren nach Anspruch 5 gelöst.

Die vorgeschlagene Schaltungsanordnung zur Versorgung einer Last, deren wesentliche elektrische Eigenschaft eine Kapazität ist, aus einer Gleichspannungsquelle hat ein Schaltelement, das im Betriebszustand abwechselnd leitend und nicht leitend geschaltet wird, und mindestens ein Bauelement, dessen wesentliche Eigenschaft eine Induktivität ist, wobei die Last parallel zu dem Bauelement in die Schaltungsanordnung einzukoppeln ist, sodass die Last und das Bauelement einen Parallelschwingkreis bilden. Das Schaltelement ist zwischen den Parallelschwingkreis und ein Grundpotential geschaltet ist und die Gleichspannungsquelle ist parallel zu der Last anzulegen. In dieser Schaltungsanordnung wird eine kapazitive Last als Kapazität in einem Parallelschwingkreis eingekoppelt und kann daher in einer Phase, in der das Schaltelement nicht leitend geschaltet ist, über das induktive Bauteil mit einer gegen die Richtung der Gleichspannung gerichteten Spannung versorgt werden. Insgesamt kann eine solche Schaltung die kapazitive Last nach einem Einschwingvorgang zumindest mit einer annäherungsweise sinusförmigen Wechselspannung versorgen und ein zumindest annäherungsweise sinusförmiger Strom fließt durch die Last. Ist die Last beispielsweise ein schwingungsfähiger, bipolarer piezoelektrischer Aktuator, wird dieser dadurch wirkungsgradstark in Schwingungen versetzt.

In einer bekannten Schaltungsanordnung ist das Schaltelement im Betriebszustand mit einer Ansteuerelektronik verbunden, die das Schaltelement zyklisch leitend und nicht leitend schaltet. Dadurch kann auch ein nicht frei schwingendes System durch externe Ansteuerung in Schwingungen versetzt werden.

In einer Ausführungsform der Erfindung wird eine Rückkopplungsspannung aus dem Parallelschwingkreis auf einen Anschluss des Schaltelementes rückgekoppelt, insbesondere über einen Rückkoppelkondensator, der mit einem Abgriff des induktiven Bauteils verbunden ist. Dadurch kann ein frei schwingendes System geschaffen werden, das keine externe Ansteuerung benötigt.

In einer weiteren Ausführungsform ist die Schaltungsanordnung dazu ausgelegt, mit einer Schaltfrequenz des Schaltelementes im Ultraschallbereich von 20 kHz - 1000 KHz, insbesondere im Bereich 30 kHz - 300 kHz, betrieben zu werden. Dies ermöglicht insbesondere das Ansteuern eines piezoelektrischen Aktuators, der in einem Zerstäuber dazu eingesetzt wird, einen feinen Flüssigkeitsnebel zu erzeugen.

In dem vorgeschlagenen Verfahren zum Versorgen einer Last, deren wesentliche elektrische Eigenschaft eine Kapazität ist, aus einer Gleichspannungsquelle, werden die folgenden Schritte durchgeführt: Als erster Schritt erfolgt das Anlegen eines Gleichspannungspotentials der Gleichspannungsquelle an einen Parallelschwingkreis, der aus der kapazitiven Last und mindestens einem parallel dazu geschalteten Bauelement, dessen wesentliche elektrische Eigenschaft eine Induktivität ist. Danach erfolgt als zweiter Schritt das leitend Schalten eines Schaltelementes, dass zwischen den Parallelschwingkreis und ein Grundpotential geschaltet ist. Daraufhin erfolgt als dritter Schritt das nicht leitend Schaltend des Schaltelementes und als fünfter Schritt die Versorgung der Last aus dem induktiven Bauteil. Die Schritte zwei bis fünf werden periodische wiederholt. Bei dem beschriebenen Verfahren wird eine kapazitive Last als Kapazität in einem Parallelschwingkreis genutzt. In Phasen, in denen ein Schaltelement nicht leitend geschaltet ist und daher kein Strom aus der Gleichspannungsquelle in den Parallelschwingkreis fließt, wird die kapazitive Last aus dem induktiven Bauteil versorgt.

Bei dem erfindungsgemäßen Verfahren werden die Schritte des leitend Schaltens und des nicht leitend Schaltens des Schaltelementes durch eine Rückkopplung einer Rückkopplungsspannung auf einen Anschluss des Schaltelementes gesteuert. Dadurch kann das System frei schwingen.

In einer bekannten Verfahrensvariante wird das Schaltelement in den Schritten des leitend Schaltens und des nicht leitend Schaltens durch eine Ansteuerelektronik angesteuert. Dadurch kann auch nicht frei schwingendes System zu einer Schwingung angeregt werden.

Die Erfindung betrifft auch ein Elektrogerät mit einer beschriebenen Schaltungsanordnung gemäß der vorliegenden Erfinudng und einer eingekoppelten kapazitiven Last, insbesondere einem piezoelektrischen Aktuator.

In einer Ausführungsform weist das Elektrogerät auch eine Gleichspannungsquelle auf, die entweder mit der Schaltungsanordnung verbunden ist oder in einem Betriebszustand mit dieser verbindbar ist. Die Gleichspannungsquelle stellt insbesondere ein Gleichspannungspotential zur Verfügung, das etwa die Hälfte der Spitzen-Spitzen-Versorgungsspannung der kapazitiven Last ist.

Das Elektrogerät kann insbesondere ein Zerstäuber zur Luftbefeuchtung oder zum Anreichern der Luft mit einer mit Duftstoffen versehenen Flüssigkeit sein oder etwa ein Inhalator zum Zerstäuben eines flüssigen Medikaments.

Die Erfindung wird im Folgenden detailliert durch exemplarische Ausführungsformen und mit Bezug auf Figuren erklärt. Dabei zeigen in den Figuren
- Fig. 1: eine Schaltungsanordnung zur Versorgung einer kapazitiven Last mit einer Wechselspannung aus einer Gleichspannungsquelle gemäß dem Stand der Technik,
- Fig. 2: eine exemplarische Schaltungsanordnung gemäß der Erfindung zur Versorgung einer kapazitiven Last mit einer Wechselspannung aus einer Gleichspannungsquelle und
- Fig. 3: eine schematische Darstellung eines Elektrogeräts, in dem eine Schaltungsanordnung gemäß der Erfindung zum Einsatz kommt.

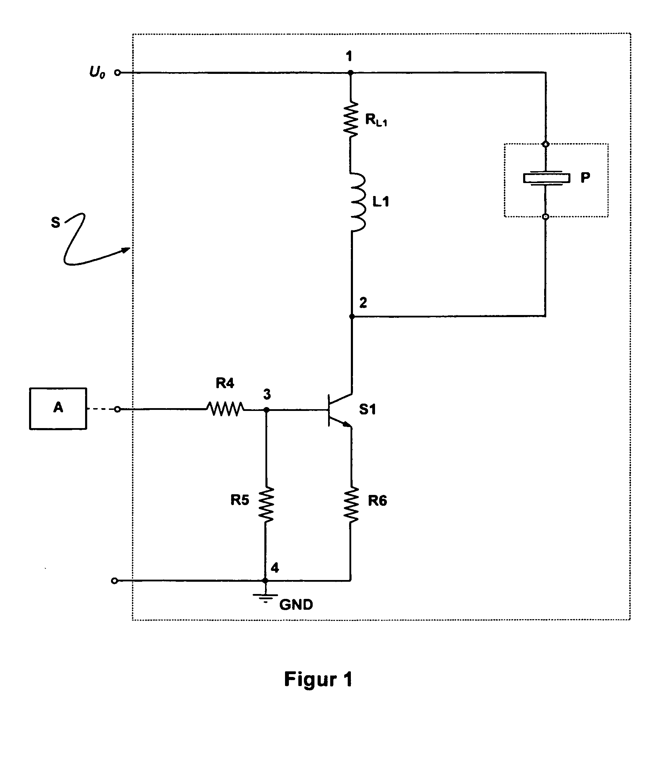

In Fig. 1 ist eine Ausführungsform einer bekannten Schaltungsanordnung S dargestellt. Es handelt sich dabei im Wesentlichen um einen LC-Parallelschwingkreis, bei dem die Kapazität durch die einkoppelbare, kapazitive Last P (also eine Last, bei der die wesentliche elektrische Eigenschaft eine Kapazität ist) gebildet wird,
wobei der Stromfluss durch den LC-Parallelschwingkreis von einem steuerbaren Schaltelement S1 gesteuert wird. In der Schaltungsanordnung S nach Fig. 1 ist eine Spule L1 (hier mit Innenwiderstand R_{L1} dargestellt) mit einem ersten Anschluss an das Gleichspannungspotential *U₀*, welches von einer Gleichspannungsquelle (nicht gezeigt) erzeugt wird, gelegt (Punkt 1 in Fig. 1) und mit einem zweiten Anschluss mit einem ersten Anschluss des Schaltelementes S1 (hier: den Kollektor eines npn-Transistors) verbunden ist. Alternativ kann als Schaltelement auch ein MOSFET eingesetzt werden. Parallel zu der Spule L1 kann die kapazitive Last P (hier: ein piezoelektrischer Aktuator) eingekoppelt werden, sodass dann ein erster Anschluss der kapazitiven Last P an dem Gleichspannungspotential *U₀* anliegt (Punkt 1 in Fig. 1) und ein zweiter Anschluss der Last P zwischen die Spule L1 und das Schaltelement S1 geschaltet ist (Punkt 2 in Fig. 1). Die Spule L1 bildet mit der eingekoppelten, kapazitiven Last P dann den Parallelschwingkreis. Ein Ansteuerungsanschluss des Schaltelements S1 (hier: die Basis des npn-Transistors) ist zumindest im Betriebszustand über einen Ansteueranschluss-Widerstand R4 mit einer Ansteuerelektronik A gekoppelt, während ein zweiter Anschluss des Schaltelementes S1 (hier: der Emitter des npn-Transistors) über einen Emitter-Widerstand R6 an das Grundpotential GND gelegt ist (Punkt 4 in Fig. 1). Der Ansteuerungsanschluss des Schaltelementes S1 ist über einen Basis-Widerstand R5 ebenfalls an das Grundpotential GND gelegt. Wesentlich bei der Schaltungsanordnung S nach Fig. 1 ist, dass die kapazitive Last als Kapazität des LC-Schwingkreises genutzt wird und das Schaltelement S1 den Stromfluss zwischen in den LC-Schwingkreis hinein steuert. Der Ansteueranschluss-Widerstand R4, der Emitter-Widerstand R6 und der Basis-Widerstand R5 sind Widerstände, die etwa der Begrenzung von Strömen dienen und eine übliche Schutzwirkung haben.

Es wird hier in einem an sich bekannten Parallelschwingkreis ein Kondensator, der die Kapazität des LC-Parallelschwingkreises zur Verfügung stellt, durch eine kapazitive Last P ersetzt, die im Betriebszustand der Schaltungsanordnung mit einer (zumindest annäherungsweise) sinusförmigen Wechselspannung versorgt wird. Die kapazitive Last P wird dabei im leitenden Zustand des Schaltelementes S1 durch das Verhalten des Parallelschwingkreises mit einer ersten (zumindest näherungsweise sinusförmigen) Spannungshalbwelle versorgt und ein (zumindest näherungsweise sinusförmiger) Strom fließt durch die Last. Die Versorgung der kapazitiven Last P mit der zweiten Halbwelle der Wechselspannung wird während der Phase, in der das Schaltelement S1 durch die externe Ansteuerelektronik A nicht leitend geschaltet ist, aus der Spule des LC-Parallelschwingkreises zur Verfügung gestellt. Die dabei an der kapazitiven Last P anliegenden Spannungsmaxima können größer sein als die angelegte Gleichspannung, sodass bei einem gegebenen Gleichspannungspotential *U₀* auch eine Last P, die eine größere Spitzen-Spitzen-Spannung (U_{peak-peak(Last)}) als die Gleichspannung, die die Gleichspannungsquelle zur Verfügung stellen kann, benötigt, versorgt werden. Bei einer beispielhaften Ausführungsform ist *U₀* ≈ ½ U_{peak-peak(Last)}.

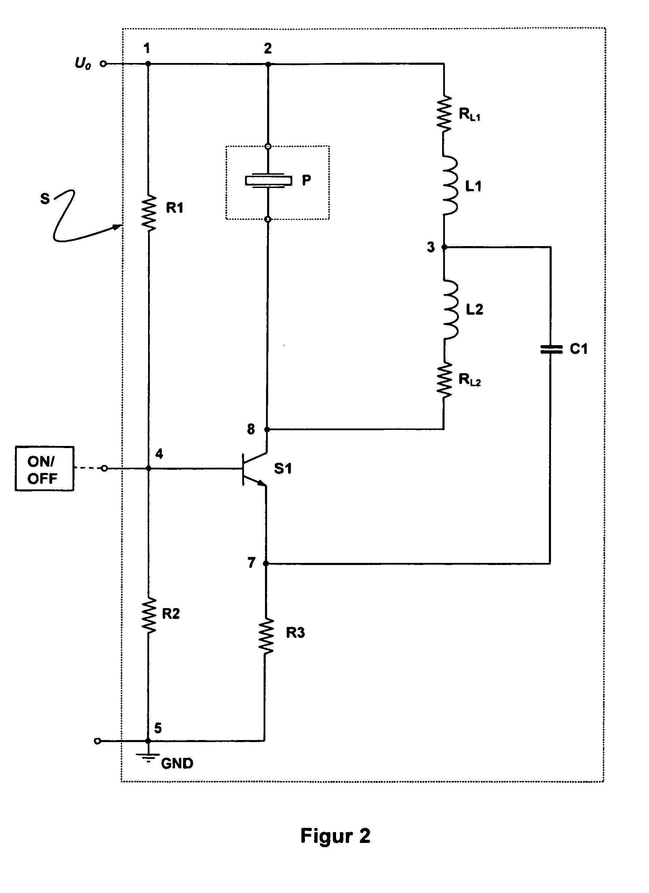

In Fig. 2 ist eine exemplarische Ausführungsform einer erfindungsgemäßen Schaltungsanordnung dargestellt. Es handelt sich dabei im Wesentlichen um einen Hartley-Oszillator in einer Basisschaltung. Eine Gleichspannungsquelle (nicht gezeigt) stellt hierbei eine Gleichspannung *U₀* zur Verfügung. Im Basiszweig eines Schaltelementes S1 ist ein Spannungsteiler aus einem ersten Widerstand R1 und einem zweiten Widerstand R2 angeordnet, wobei der erste Widerstand R1 mit einem ersten Anschluss an dem Gleichspannungspotential *U₀* anliegt (Punkt 1 in Fig. 2) und mit seinem zweiten Anschluss mit dem ersten Anschluss des zweiten Widerstands R2 verbunden ist. Der zweite Anschluss des zweiten Widerstands R2 liegt am Grundpotential GND (Erde) an (Punkt 5 in Fig. 2). Das Schaltelement S1 (hier: ein bipolarer npn-Transistor) ist mit seinem Ansteuerungsanschluss (hier: die Basis des npn-Transistors) zwischen den ersten und den zweiten Widerstand R1 und R2 geschaltet (Punkt 4 in Fig. 2). Es ist vorgesehen, dass eine kapazitive Last in den Kollektorzweig des Schaltelements S1 eingekoppelt werden kann. In Fig. 2 ist ein piezoelektrischer Aktuator als kapazitive Last P im eingekoppelten Zustand dargestellt. Der erste Anschluss der kapazitiven Last P liegt dabei an dem Gleichspannungspotential *U₀* an (Punkt 2 in Fig. 2) und der zweite Anschluss der Last P ist mit dem ersten Anschluss des Schaltelementes S1 verbunden (hier: mit dem Kollektor des npn-Transistors). Parallel zu der kapazitiven Last P ist eine Spule mit einem Abgriff angeordnet. Alternativ können auch zwei in Reihe geschaltete Spulen verwendet werden. Der Einfachheit halber wird im Weiteren von einer ersten Spule und einer zweiten Spule gesprochen. Eine erste Spule L1 (mit hier dargestelltem Innenwiderstand R_{L1}) ist mit ihrem ersten Anschluss mit dem Gleichspannungspotential *U₀* verbunden (Punkt 2 in Fig. 2) und mit ihrem zweiten Anschluss mit dem ersten Anschluss der zweiten Spule L2 (hier mit Innenwiderstand R_{L2} dargestellt) verbunden. Der zweite Anschluss der zweiten Spule L2 ist mit dem ersten Anschluss des Schaltelementes S1 (hier: mit dem Kollektor des npn-Transistors) verbunden. Ein Rückkoppelkondensator C1 ist über seinen ersten Anschluss mit dem Abgriff, der zwischen der ersten und der zweiten Spule L1 und L2 eingreift (Punkt 3 in Fig. 2) verbunden. Der Rückkoppelkondensator C1 ist mit seinem zweiten Anschluss mit dem zweiten Anschluss des Schaltelementes S1 verbunden (hier: über Punkt 7 in Fig. 2 mit dem Emitter des npn-Transistors). Der zweite Anschluss des Schaltelementes S1 (hier der Emitter des npn-Transistors) liegt über einen (im Emitterzweig des Schaltelementes S1 angeordneten) dritten Widerstand R3 am Grundpotential GND (Punkt 5 in Fig. 2).

Bei dem induktiven Spannungsteiler, der aus der ersten und der zweiten Spule gebildet ist, ist es nicht notwendig, dass die erste und die zweite Spule L1 und L2 gleiche Induktivität haben, aber es ist eine sinnvolle Ausgestaltung.

Bei der Schaltungsanordnung S nach Fig. 2 bestimmt der Spannungsteiler aus dem ersten und zweiten Widerstand R1 und R2 den Arbeitspunkt des Schaltelementes S1. Der Rückkoppelkondensator C1 sorgt für die Mitkopplung einer Rückkoppelspannung auf den zweiten Anschluss des Schaltelementes S1 (hier: den Emitter des npn-Transistors). Der dritte Widerstand R3 dient in bekannter Weise der Anhebung des Emitterpotentials für die Rückkopplung und kann für eine geringe Dämpfung auch durch eine Spule ersetzt werden. Wird die Schaltungsanordnung S mit eingekoppelter Last P in Betrieb genommen (etwa indem die Gleichspannung eingeschaltet wird oder indem das Schaltelement S1 über eine externe ON/OFF-Ansteuerelektronik eingeschaltet wird, wenn die Gleichspannung bereits anliegt), dann hat die Last P, deren wesentliche elektrische Eigenschaft eine Kapazität ist, keinen Widerstand und legt das Gleichspannungspotential an den ersten Anschluss des Schaltelementes. Sobald sich die Kapazität der Last P auflädt, fällt eine Spannung an der Last P ab, die das Potential am ersten Anschluss des Schaltelementes S1 reduziert. Der Rückkoppelkondensator C1, der an den zweiten Anschluss des Schaltelementes S1 gekoppelt ist (hier: an den Emitter des npn-Transistors) koppelt eine Rückkoppelspannung zurück, die die Schwingung einsetzen lässt und auch aufrechterhält. In der Phase, in der das Schaltelement S1 leitend geschaltet ist, wird die kapazitive Last P mit einer ersten Halbwelle einer nahezu sinusförmigen Wechselspannung versorgt und eine nahezu sinusförmiger Strom fließt durch die kapazitive Last P. Durch das bekannte Verhalten von komplexen Spannungen in einem Parallelschwingkreis kann die maximal anliegende Spannung an der Last P größer sein als die Gleichspannungsquelle. Sobald das Schaltelement S1 durch die variierenden, am ersten und am zweiten Anschluss anliegenden Potentiale in einen nicht leitenden Zustand geschaltet wird, stoppt der Stromfluss aus der Gleichspannungsquelle durch den LC-Schwingkreis. Die in der ersten und der zweiten Spule L1 und L2 gespeicherte Energie wird dann entgegengesetzt der anliegenden Gleichspannung aus den Spulen entladen und sorgt so für eine Versorgung der kapazitiven Last P mit einer zweiten Spannungs-Halbwelle, die der sinusförmigen Spannungs-Halbwelle an der Last P während der leitenden Phase des Schaltelementes S1 entgegengerichtet ist. Die in Fig. 2 gezeigte Hartley-Schaltung zur Versorgung der kapazitiven Last P ist frei schwingend und bedarf keiner externen Ansteuerung des Schaltelementes S1. Nach einem Einschwingvorgang wird die Last P mit einer sinusförmigen Wechselspannung versorgt, bei der die eine Spannungshalbwelle während der leitenden Phase des Schaltelementes S1 an der Last abfällt und die zweite Spannungshalbwelle wird während der nicht leitenden Phase des Schaltelementes durch das Bauteil L zur Verfügung gestellt.

Eine Hartley-Schaltung ist zwar an sich bekannt, jedoch zur Versorgung einer externen Last mit einer Wechselspannung (etwa indem die erste und zweite Spule L1 und L2 als primärseitige Spule eines Transformators verwendet wird, wobei die Last an die sekundärseitige Spule des Transformators geschaltet wird). Erfindungsgemäß wird jedoch eine kapazitive Last P mit einer sinusförmigen Wechselspannung versorgt, wobei die kapazitive Last P (hier ein piezoelektrischer Aktuator) als die zur Induktivität der Spule parallel geschaltete Kapazität eingesetzt wird, also zur Versorgung der Last kein zusätzlicher Kondensator notwendig ist. Die Spannungsmaxima, die dabei an der Last P zum Anliegen kommen, sind größer als das Gleichspannungspotential, das von der Gleichspannungsquelle zur Verfügung gestellt wird.

Ist die Last ein piezoelektrischer Aktuator, der eine Kapazität von etwa *C_{P}* = 5 nF hat, dann können bei einer angestrebten Schaltfrequenz von etwa *f* = 90 kHz Spuleninduktivitäten von *L_{L}* = 150 - 330 µH gewählt werden, wobei die Schaltungsanordnung S auch bei höheren und niedrigeren Werten noch funktioniert (aber nicht in der gleichen Güte wie bei optimal aufeinander abgestimmten Bauteilen). Die Kapazität des Rückkoppelkondensators C1 in der Hartley-Schaltung kann abhängig vom Schaltelement S1 zu etwa *C_{C1}* = 20 - 100 nF gewählt werden und der dritte Widerstand R3 zu etwa 20 - 200 Ω. Die Gleichspannungsquelle U₀ ist bei den angegebenen Werten so zu wählen, dass sie ein Gleichspannungspotential *U₀* zur Verfügung stellt, das etwa halb so groß ist wie die benötigte Spitzen-Spitzen-Versorgungsspannung U_{peak-peak(Last)} der Last P (etwa ungefähr 30 V, wenn eine U_{peak-peak(Last)} von etwa 60 V erzielt werden soll). Generell kann die Schaltfrequenz *f* im Ultraschallbereich von 20 kHz - 1000 kHz, insbesondere im Bereich von 30 kHz - 300 kHz liegen.

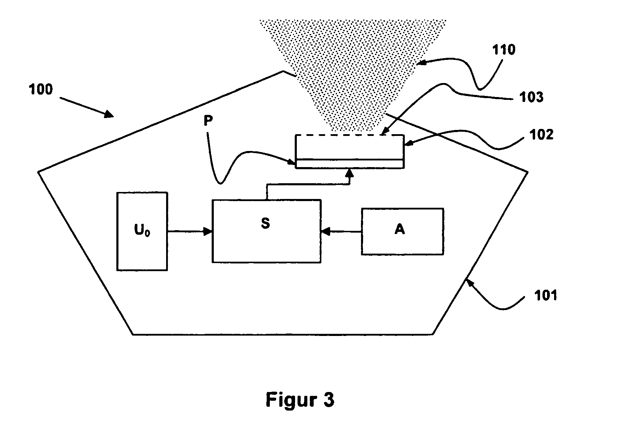

In Fig. 3 ist schematisch ein exemplarisches Beispiel für ein Elektrogerät 100 gezeigt, in dem eine Schaltungsanordnung S gemäß Fig. 2 zum Einsatz kommt. Die Schaltungsanordnung S ist an eine Ansteuerelektronik A gekoppelt und mit einer Gleichspannungsquelle U₀ verbunden. Die Gleichspannungsquelle kann etwa eine Batterie oder ein Akkumulator sein. Alternativ kann das Elektrogerät durch eine externe Gleichspannungsquelle versorgt werden. Mit der Schaltungsanordnung S ist ein piezoelektrischer Aktuator P als Last verbunden. Der piezoelektrische Aktuator P wird durch die Schaltungsanordnung S zur Vibration angeregt. Der piezoelektrische Aktuator wirkt dabei mechanisch auf eine Flüssigkeit ein, die sich in einem Reservoir 102 befindet und durch die mechanische Vibrationsanregung durch die Poren einer Membran 103 in an sich bekannter Weise gepresst wird, sodass ein Nebel 110 aus feinsten Flüssigkeitströpfchen gebildet wird. Der Nebel kann etwa zur Luftbefeuchtung dienen oder als zu inhalierender Nebel.

## Patentansprüche

1. Schaltungsanordnung (S) zur Versorgung einer Last (P), deren wesentliche elektrische Eigenschaft eine Kapazität ist, aus einer Gleichspannungsquelle (U₀) mit
o einem Schaltelement (S1), das im Betriebszustand abwechselnd leitend und nicht leitend geschaltet wird, und
o mindestens einem Bauelement (L1, L2), dessen wesentliche Eigenschaft eine Induktivität ist,
wobei die Last (P) parallel zu dem Bauelement (L1, L2) in die Schaltungsanordnung (S) einzukoppeln ist, sodass die Last (P) und das Bauelement (L1, L2) einen Parallelschwingkreis bilden, das Schaltelement (S1) zwischen den Parallelschwingkreis und ein Grundpotential (GND) geschaltet ist und die Gleichspannungsquelle parallel (U₀) zu der Last anzulegen ist, **dadurch gekennzeichnet, dass** das Schaltelement (S1) im Betriebszustand durch eine Rückkopplung einer Rückkopplungsspannung aus dem Parallelschwingkreis an einen Anschluss des Schaltelementes (S1) periodisch leitend und nicht leitend geschaltet wird.

2. Schaltungsanordnung (S) nach Anspruch 1, wobei die Rückkopplung der Rückkoppelspannung über einen Rückkoppelkondensator (C1) erfolgt, der mit einem Abgriff (3) des Bauelelements (L1, L2) verbunden ist.

3. Schaltungsanordnung (S) nach Anspruch 2, wobei das Bauelement (L1, L2) zwei in Reihe geschalteten Spulen (L1, L2) aufweist und wobei der Rückkoppelkondensator (C1) über einen ersten Anschluss mit dem Abgriff (3) verbunden ist, der zwischen den Spulen (L1, L2) eingreift.

4. Schaltungsanordnung (S) nach einem der Ansprüche 1 bis 3, wobei die Schaltungsanordnung (S) dazu ausgelegt ist, mit einer Schaltfrequenz des Schaltelementes (S1) im Ultraschallbereich von 20 kHz - 1000 KHz, insbesondere im Bereich 30 kHz-300 kHz, betrieben zu werden.

5. Verfahren zum Versorgen einer Last (P), deren wesentliche elektrische Eigenschaft eine Kapazität ist, aus einer Gleichspannungsquelle (U₀), das die folgenden Schritte umfasst:
o Anlegen eines Gleichspannungspotentials (*U₀*) der Gleichspannungsquelle (U₀) an einen Parallelschwingkreis, der aus der Last (P) und mindestens einem parallel dazu geschalteten Bauelement (L1, L2), dessen wesentliche elektrische Eigenschaft eine Induktivität ist,
o leitend Schalten eines Schaltelementes (S1), dass zwischen den Parallelschwingkreis und ein Grundpotential (GND) geschaltet ist,
o nicht leitend Schaltend des Schaltelementes (S1),
o Versorgung der Last (P) aus dem Bauteil (L1, L2) und
o periodisches Wiederholen der Schritte des leitend Schaltens und des nicht leitend Schaltens des Schaltelementes und der Versorgung der Last,
**dadurch gekennzeichnet, dass** die Schritte des leitend Schaltens und des nicht leitend Schaltens durch eine Rückkopplung einer Rückkopplungsspannung auf einen Anschluss des Schaltelementes gesteuert werden.

6. Elektrogerät (100), insbesondere Vaporisator oder Inhalator, mit einer Schaltungsanordnung (S) nach einem der Ansprüche 1 bis 4 und einer in den Parallelschwingkreis eingekoppelten Last (P).

7. Elektrogerät (100) nach dem vorangegangenen Anspruch, wobei das Elektrogerät (100) eine Gleichspannungsquelle (U₀) aufweist, die mit der Schaltungsanordnung (S) verbunden ist oder in einem Betriebszustand mit der Schaltungsanordnung (S) verbindbar ist.

8. Elektrogerät (100) nach einem der Ansprüche 6 bis 7, wobei die Gleichspannungsquelle (U₀) eine Gleichspannung (*U₀*) zur Verfügung stellt, die etwa halb so groß ist wie die notwendige Spitzen-Spitzen-Versorgungsspannung der Last (P).

## Claims

1. A circuit arrangement (S) for supplying a load (P) whose essential electrical property is capacitance from a direct voltage source (U₀), with
a switch element (S1) which, in the operational state, is alternately switched between conductive and non-conductive states and
at least one component (L1, L2) whose essential property is inductance,
wherein the load (P) is to be coupled into the circuit arrangement (S) parallel to the component (L1, L2) so that the load (P) and the component (L1, L2) form a parallel resonant circuit; the switch element (S1) is switched between the parallel resonant circuit and a base potential (GND); and the direct voltage source is to be applied in parallel (U₀) with the load, **characterized in that** the switch element (S1) in the operating state is switched to a conductive state and a non-conductive state by feeding a feedback voltage back from the parallel resonant circuit to a terminal of the switch element (S1).

2. A circuit arrangement (S) in accordance with Claim 1, wherein the feedback voltage is fed back via a feedback capacitor (C1) which is connected to a tap (3) of the component (L1, L2).

3. A circuit arrangement (S) in accordance with Claim 2, wherein the component (L1, L2) has two coils (L1, L2) connected in series, and wherein the feedback capacitor (C1) is connected via a first terminal (3) to the tap (3) which acts between the coils (L1, L2).

4. A circuit arrangement (S) in accordance with one of the Claims 1 to 3, wherein the circuit arrangement (S) is designed to be operated with a switching frequency of the switch element (S1) in the ultrasound range of 20 kHz - 1000 KHz, in particular in the range of 30 kHz - 300 kHz.

5. A method for supplying a load (P) whose essential electric property is capacitance from a direct voltage source (U₀), which method comprises the following steps:
the application of a direct voltage potential (*U₀*) of the direct voltage source (U₀) to a parallel resonant circuit comprising the load (P) and at least one component (L1, L2) connected in parallel with this whose essential electrical property is inductance, conductive switching of a switching element (S1) which is switched between the parallel resonant circuit and a base potential (GND),
non-conductive switching of the switch element (S1),
supplying of the load (P) from the component (L1, L2) and
periodic repetition of the conductive switching and non-conductive switching of the switch element and of the supply of the load, **characterized in that** the steps of the conductive switching and of the non-conductive switching are controlled by feeding a feedback voltage back to a terminal of the switch element.

6. An electrical device (100), in particular a vaporizer or inhaler, having a circuit arrangement (S) according to one of the Claims 1 to 4 and a load (P) coupled into the parallel resonant circuit.

7. An electrical device (100) according to the preceding Claim, wherein the electrical device (100) has a direct voltage source (U₀) which is connected to the circuit arrangement (S) or may be connected to the circuit arrangement (S) in the operational state.

8. An electric device (100) in accordance with one of the Claims 6 to 7, wherein the direct voltage source (U₀) provides a direct voltage (*U₀*) which is approximately half as high as the required peak-to-peak supply voltage of the load (P).

## Revendications

1. Circuiterie (S) pour l'alimentation d'une charge (P), dont la propriété électrique essentielle est une capacité, à partir d'une source de tension continue (U₀) avec
o un élément de commutation (S1), commuté de manière alternative de façon conductrice et non-conductrice à l'état de fonctionnement et
o au moins un composant (L1, L2), dont la propriété électrique essentielle est une inductance,
dans laquelle la charge (P) doit être appliquée de manière parallèle au composant (L1, L2) dans la circuiterie (S), de telle manière que la charge (P) et le composant (L1, L2) forment un circuit oscillant parallèle, l'élément de commutation (S1) est monté entre le circuit oscillant parallèle et un potentiel de base (GND) et la source de tension continue (U₀) est à appliquer de manière parallèle à la charge, **caractérisée en ce que** l'élément de commutation (S1), dans l'état de fonctionnement, est connecté, par le biais d'une rétroaction d'une tension de rétroaction depuis le circuit oscillant parallèle, à un raccord de l'élément de commutation (S1) de manière périodique entre un état conducteur et non-conducteur.

2. Circuiterie (S) selon la revendication 1, dans laquelle la rétroaction de la tension de rétroaction s'effectue par un condensateur de rétroaction (C1), qui est relié à une prise (3) du composant (L1, L2).

3. Circuiterie (S) selon la revendication 2, dans laquelle le composant (L1, L2) présente deux bobines (L1, L2) connectées en série et dans laquelle le condensateur de rétroaction (C1) est relié avec la prise (3) par le biais d'un premier raccord, qui intervient entre les deux bobines (L1, L2).

4. Circuiterie (S) selon l'une des revendications 1 à 3, dans laquelle la circuiterie (S) est conçue pour être utilisée avec une fréquence de commutation de l'élément de commutation (S1) comprise dans le domaine des ultrasons compris entre 20 kHz et 1000 KHz, en particulier dans le domaine compris entre 30 kHz et 300 kHz.

5. Procédé d'alimentation d'une charge (P), dont la propriété électrique essentielle est une capacité, à partir d'une source de tension continue (U₀), comprenant les étapes suivantes :
o application d'un potentiel de tension continue (*U₀*) de la source de tension continue (U₀) sur un circuit oscillant parallèle, constitué de la charge (P) et d'au moins un composant (L1, L2) connecté en parallèle à celle-ci, dont la capacité électrique essentielle est une inductance,
o commutation d'un élément de commutation (S1) pour qu'il soit conducteur, qui est connecté entre le circuit oscillant parallèle et un potentiel de base (GND),
o commutation de l'élément de commutation (S1) pour qu'il ne soit pas conducteur,
o alimentation de la charge (P) à partir du composant (L1, L2) et
o répétition périodique des étapes de commutation dans l'état conducteur et non conducteur de l'élément de commutation et d'alimentation de la charge,
**caractérisé en ce que** les étapes de commutation à l'état conducteur et à l'état non-conducteur sont commandées par le biais d'une rétroaction d'une tension de rétroaction sur un raccord de l'élément de commutation.

6. Appareil électrique (100), notamment vaporisateur ou inhalateur, comprenant une circuiterie (S) selon une des revendications 1 à 4 et une charge (P) couplée dans un circuit oscillant parallèle.

7. Appareil électrique (100) selon la revendication précédente, dans lequel l'appareil électrique (100) présente une source de tension continue (U₀), qui est reliée à la circuiterie (S) ou peut être reliée, dans un état de fonctionnement, avec la circuiterie (S).

8. Appareil électrique (100) selon une des revendications 6 à 7, dans lequel la source de tension continue (U₀) produit une tension continue (*U₀*)*,* qui est environ la moitié de la tension d'alimentation de crête à crête nécessaire de la charge (P).
